# EUROPEAN PATENT APPLICATION

(11) **EP 1 079 433 A2**
(43) Date of publication of application: **28.02.2001**
(21) Application number: 00117329.3
(22) Date of filing: 21.08.2000
(51) Int. Cl.: H01L 23/498, H01L 23/36

(54) **Ball grid array package having two ground levels**

(30) Priority: 27.08.1999 US 151016 P
(71) Applicant: Texas Instruments Incorporated, Dallas, Texas 75251 (US)
(72) Inventor: James, Richard D., Plano, Texas 75074 (US); Lamson Michael A., Westminster, Texas 75485 (US)
(74) Representative: Schwepfinger, Karl-Heinz, Dipl.-Ing.

(57) **Abstract**

A high-performance integrated circuit package(100) having signal and power lines, preferably a high I/O ball grid array package, comprising a first electrically conductive layer (115) suitable to provide ground potential; a second electrically conductive layer (105), also at ground potential; said first and second electrically conductive layers positioned on opposite sides of said signal and power lines so that self and mutual inductances are lowered, whereby package electrical noise and cross talk are reduced and circuit switching and speed are increased.

## Description

### FIELD OF THE INVENTION

The present invention is related in general to the field of semiconductor devices and processes and more specifically to structure, materials and fabrication of high-performance plastic ball grid array packages designed for flip-chip assembly.

### DESCRIPTION OF THE RELATED ART

Ball Grid Array (BGA) packages have emerged as an excellent packaging solution for integrated circuit (IC) chips with high input/output (I/O) count. BGA packages use sturdy solder balls for surface mount connection to the "outside world" (typically plastic circuit boards, PCB) rather sensitive package leads, as in Quad Flat Packs (QFP), Small Outline Packages (SOP), or Tape Carrier Packages (TCP). Some BGA advantages include ease of assembly, use of surface mount process, low failure rate in PCB attach, economic use of board area, and robustness under environmental stress. The latter used to be true only for ceramic BGA packages, but has been validated in the last few years even for plastic BGAs. From the standpoint of high quality and reliability in PCB attach, BGA packages lend themselves much more readily to a six-sigma failure rate fabrication strategy than conventional devices with leads to be soldered.

A BGA package generally includes an IC chip, a multi-layer substrate, and a heat spreader. The chip is generally mounted on the heat spreader using a thermally conductive adhesive, such as an epoxy. The heat spreader provides a low resistance thermal path to dissipate thermal energy, and is thus essential for improved thermal performance during device operation, necessary for consistently good electrical performance. Further, the heat spreader provides structural and mechanical support by acting as a stiffener, adding rigidity to the BGA package, and may thus be referred to as a heat spreader/stiffener.

One of the substrate layers includes a signal "plane" that provides various signal lines, which can be coupled, on one end, to a corresponding chip bond pad using a wire bond (or to a contact pad using flip-chip solder connection). On the other end, the signal lines are coupled with solder "balls" to other circuitry, generally through a PCB. These solder balls form the array referred to in a BGA. Additionally, a ground plane will generally be included on one of the substrate layers to serve as an active ground plane to improve overall device performance by lowering the inductance, providing controlled impedance, and reducing cross talk. These features become the more important the higher the BGA pin count is.

In contrast to the advantages of the BGA packages, prevailing solutions in BGA packages have lagged in performance characteristics such as power dissipation and the ability to maintain signal integrity in high speed operation necessary for devices such as high speed digital signal processors (DSP) and mixed signal products (MSP). Electrical performance requirements are driving the need to use multi-layer copper-laminated resin substrates (previously ceramic). As clock frequencies and current levels increase in semiconductor devices, the packaging designs are challenged to provide acceptable signal transmission and stable power and ground supplies. Providing stable power is usually achieved by using multiple planes in the package, properly coupled to one another and to the signal traces. In many devices, independent power sources are needed for core operation and for output buffer supply but with a common ground source.

As for higher speeds, flip chip assembly rather than wire bonding has been introduced. Compared to wire bonding within the same package outline, flip chip assembly offers greatly reduced IR drop to the silicon core circuits; significant reduction of power and ground inductances; moderate improvement of signal inductance; moderate difference in peak noise; and moderate reduction in pulse width degradation.

In order to satisfy all these electrical and thermal performance requirements, packages having up to eight metal layers have been introduced. The need, however, of high numbers of layers is contrary to the strong market emphasis on total semiconductor device package cost reduction. This emphasis is driving an ongoing search for simplifications in structure and materials, of course with the constraint that electrical, thermal and mechanical performances should be affected only minimally.

The complexity and cost of the BGA packages are also influenced by the number of interconnections or vias that must be fabricated in the substrate layers to provide a path to connect each of the solder balls to either the ground plane, the power planes, or desired signal lines of the signal plane. Each via requires the formation of an electrically conductive layer on the internal walls of the via, to ensure a complete electrical path. Generally, the metallization of the internal walls of each via increases the overall complexity. Consequently, multiple vias and multiple substrate layers result not only in higher BGA fabrication costs, but also lower yields.

In U.S. Patent Application Serial # 60/147,596, filed Aug.06, 1999, to which this invention is related, the structure and fabrication method of a high-performance, high I/O plastic BGA has been discussed. There are only two metal layers, one of which is exclusively devoted to a ground plane. The package has thus a small thickness and a low cost. But the remaining metal layer has a crowded routing density, since all signal and power lines of the high I/O device have to share this one layer. Consequently, the Vcc inductances are too high for fast-speed processor devices. The high inductance is the source of unacceptable electrical noise and cross talk, severely limiting device speed.

An urgent need has therefore arisen to break this vicious cycle and conceive a concept for a low-cost, yet high performance BGA package structure. Preferably, this structure should be based on a fundamental design concept flexible enough to be applied for different semiconductor product families and a wide spectrum of design and assembly variations. It should not only meet high electrical and thermal performance requirements, but should also achieve improvements towards the goals of enhanced process yields and device reliability. Preferably, these innovations should be accomplished using the installed equipment base so that no investment in new manufacturing machines is needed.

### SUMMARY OF THE INVENTION

According to the present invention, a high-performance IC package having signal and power lines is provided, which has a first electrically conductive layer suitable to provide ground potential, and in addition a second electrically conductive layer, provided by the heat spreader and also at ground potential, positioned at opposite sides of the signal and power lines so that self and mutual inductances are lowered, thereby strongly reducing package electrical noise and cross talk and increasing IC switching and speed.

It is an aspect of the present invention to provide an insulating film protecting the exposed surface of the ground layer. This insulating film has a plurality of openings filled with metal suitable for solder ball attachment for providing connection to other circuitry.

Another aspect of the invention is to provide an insulating layer between the layer configured into the signal and power lines and the first electrically conductive layer, connected to ground potential. This insulating layer is traversed by a plurality of metal-filled vias. A select number of these vias connect at one end to the layer at ground potential and at the other end to electrically conductive adhesive which is attached to the metallic heat spreader.

Another aspect of the invention is to provide another insulating film protecting the exposed surfaces of the signal and power lines. This insulating film has a thinness suitable to decrease cross talk, inductance and characteristic impedance of the signal lines. Furthermore, this insulating film has a first multitude of openings filled with metal suitable for attaching chip solder bumps, and a second multitude of metal-filled openings suitable to contact the electrically conductive adhesive which is attached to the metallic spreader.

Another aspect of the invention is to make the adhesive, which attaches the heat spreader to the protective insulating film, electrically conductive. This feature permits the application of ground potential to the heat spreader, thus moving ground potential into close proximity to signal and power lines.

Another aspect of the invention is to utilize existing semiconductor fabrication processes and to reach the electrical device goals without the cost of equipment changes and new capital investment, by using the installed fabrication equipment.

Another aspect of the invention is to provide design and fabrication solutions such that they are flexible enough to be applied for different semiconductor high-performance device families and a wide spectrum of high speed, high power design and assembly variations.

Another aspect of the invention is to reduce the thickness of the BGA device including the heat spreader substantially so that the BGA device can readily be employed in a variety of new products requiring thin semiconductor components.

These aspects have been achieved by the electrical design of the high I/O ball grid array substrate in combination with the heat spreader, and by an assembly method of the heat spreader for flip-chip IC devices, suitable for mass production.

The technical advances represented by the invention, as well as the aspects thereof, will become apparent from the following description of the preferred embodiments of the invention, when considered in conjunction with the accompanying drawings and the novel features set forth in the appended claims.

### BRIEF DESCRIPTION OF THE DRAWINGS

FIG. 1 is a schematic and simplified cross section of a portion of the Ball Grid Array (BGA) package having a substrate and heat spreader according to the invention.
FIG. 2 is a simplified cross section of a portion of the BGA package with conductive adhesive for the heat spreader according to the invention.
FIG. 3 illustrates the dependence of the inductance on the geometrical separation from the second ground plane, established according to the invention
FIG. 4 illustrates the inductance improvement derived from establishing the second ground plane, as compared to the inductance without the second ground plane.

### DETAILED DESCRIPTION OF THE PREFERRED EMBODIMENTS

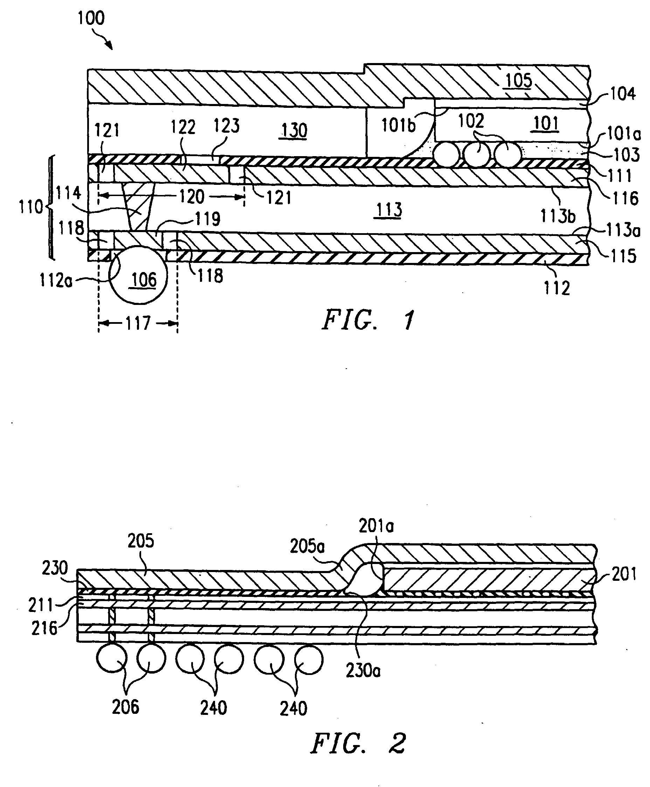

FIG. 1 is a simplified and schematic cross sectional view of a portion of the high-performance, high input/output (I/O) Ball Grid Array (BGA) package of the invention, generally designated 100. Using solder bumps 102 in flip-chip technology, the active surface 101a of the integrated circuit chip 101 is attached to openings in the insulating film 111 of substrate 110, facing the active chip surface 101a. Chip 101 is commonly made of silicon or silicon germanium and has a thickness typically in the range of about 200 to 375 µm. The number of I/O's typically is in the range from about 100 to 600; approximately one half of these I/O's serve signal lines, the other half is dedicated to power and ground potentials.

The solder bumps 102 connecting the chip I/O's to the substrate 110 are usually small in diameter, typically about 100 to 120 µm with a range of ± 10 µm, and comprise attach materials selected from a group consisting of tin, lead/tin alloys, indium, indium/tin alloys, solder paste, and conductive adhesive compounds. Solder bumps are deposited (sometimes in the wafer fabs) in a number of geometrical shapes and adopt a variety of shapes (typically more flat than elongated) in the flip-chip solder reflow process. Following the flip-chip attachment, any gaps between chip 101 and substrate 110, and also between the solder bumps 102, are filled with a polymeric encapsulant 103. This encapsulant typically is a polymeric precursor made of an epoxy base material filled with silica and anhydrides, requiring thermal energy for curing to form a polymeric encapsulant.

The heat spreader 105 is positioned on the passive surface 101b of chip 101 and attached to this surface by the attach material 104 (commonly polyimide or epoxy based adhesive, typical thickness range from about 50 to 130 µm). The heat spreader is typically made of copper, sometimes with a gold flash; its thickness is usually in the range from about 150 to 300 µm, but may be thinner or thicker dependent on the specific package type. The heat spreader enhances the rapid distribution of thermal energy and heat dissipation and thus improves the overall thermal performance of the device significantly.

Solder balls are attached to the plurality of openings in the outermost insulating film 112 of substrate 110. As defined herein, the term solder "balls" does not imply that the solder contacts are necessarily spherical. They may have various forms, such as semispherical, half-dome, truncated cone, or generally bump. The exact shape is a function of the deposition technique (such as evaporation, plating, or prefabricated units) and reflow technique (such as infrared or radiant heat), and the material composition. The solder balls usually have a diameter in the range from about 0.1 to 0.75 mm. Several methods are available to achieve consistency of geometrical shape by controlling amount of material and uniformity of reflow temperature. The solder balls 106 comprise attach materials selected from a group consisting of tin/lead, tin/indium, tin/silver, tin/bismuth, solder paste, and conductive adhesive compounds.

Several of these solder balls provide electrical ground potential to the package; by way of example, FIG. 1 shows a solder ball 106 intended for ground potential. The majority of the solder balls (as indicated in FIG. 2) are intended to provide connections for the device signal and power lines.

The two insulating films 111 and 112 of the substrate serve as protection for the substrate metal patterns and also as solder masks. The films preferably are glass-filled epoxies, polyimides, acrylics or other photo-imageable materials suitable as solder masks and thus able to sustain repeated temperature excursions needed to accomplish repeated solder reflow processes.

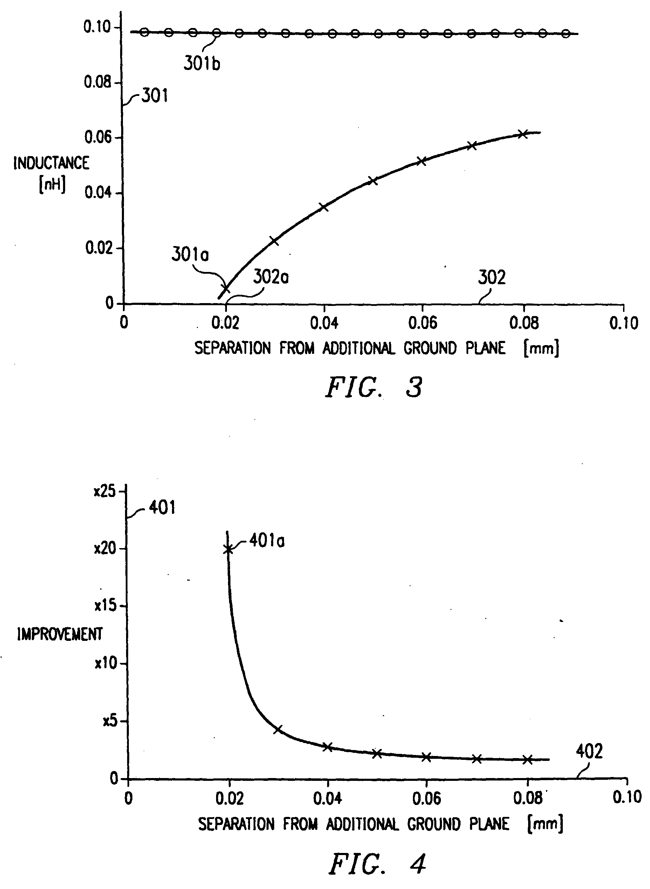

While the thickness range of these insulating films 111 and 112 is typically from about 50 to 100 µm, it is an important aspect of the present invention to reduce the thickness to the range from about 10 to 30 µ. At this thinness, the electrical performance of the package can be substantially improved by decreasing inductance, characteristic impedance and cross talk of the signal lines (see FIGs. 3 and 4).

The openings (for example, 112a) for solder bump and solder ball attachments are made of copper including a flash of gold, palladium or platinum, or other wettable and solderable metals.

As FIG. 1 schematically shows, the substrate 110 consists of an insulating layer 113 having a first surface 113a, a second surface 113b, and a plurality of vias 114 filled with metal. The preferred metal is copper, but tungsten or any other electrically conductive materials are suitable. The insulating layer 113 has preferably a thickness in the range from about 50 to 120 µm and is made of organic material selected from a group consisting of polyimide, polymer strengthened by glass fibers, FR-4, FR-5, and BT resin. The dielectric constant is preferably between 3 and 5.

Attached to the first substrate surface 113a is a metal layer 115, configured to provide electrical ground potential. Attached to the second surface 113b is a metal layer 116, configured to provide a plurality of electrical signal lines, further a plurality of first electrical power lines, and further a plurality of second electrical power lines. The total thickness of the substrate 110 is preferably in the range from about 150 to 300 µm.

The two metal layers 115 and 116 have a thickness preferably in the range of about 7 to 15 µm, and are made, for example, of copper, brass, aluminum, silver, or alloys thereof. Metal layer 115, herein called the "first metal layer", is designed to provide the electrical ground potential. It has a plurality of openings 117, each having an electrically insulated ring 118 and metal 119 in the core for outside electrical contacts. This core metal is solderable and connects to the solder balls 106.

Metal layer 116, herein called the "second metal layer", is designed so that a portion is configured as a plurality of electrical signal lines, a further portion as a plurality of first electrical power lines, and a final portion as a plurality of second electrical power lines. An individual signal line may have a width between about 25 and 50 µm, and one signal line may be spaced to the adjacent signal line by insulating material of a width from about 20 to 50 µm. An individual power line may have a width from about 200 to 500 µm.

Metal layer 116 further accommodates a plurality of openings 120, each having an electrically insulated ring 121 and metal 122 in the core for contacting the metal-filled openings 123 in the insulating film 111. Metals 122 and 123 are typically made of copper including a flash of gold.

It is an important aspect of the present invention to attach the portions of heat spreader 105, which are remote from chip 103, to the insulating film 111 of substrate 110 using the electrically conductive adhesive material 130. This material is selected from a group consisting of silver-filled epoxy, plastic spheres or rods covered with metal, a multitude of electrically conductive fibers extending through an electrically nonconductive and adhesive layer form one surface to the opposite surface, or generally metal particles suspended in plastic and adhesive materials. Dependent on the shape of the heat spreader, the thickness of adhesive 130 may vary from the thinness of attach material 104 (about 50 µm) to the thickness of about 150µm.

FIG. 1 shows the major aspect of the present invention that a continuous electrical path for ground potential is established from the "outside world" and solder ball 106 through substrate 110 to the electrically conductive adhesive material 130 and the heat spreader 105. This ground potential is in addition to the ground potential applied to the first metal layer 115. Consequently, these two electrically conductive layers at ground potential are on opposite sides of the signal and power lines of the second metal layer 116. Furthermore, the thinness of insulating film 111 brings the additional ground potential into close proximity of the signal lines in layer 116. As a result, this solution provides two important electrical advantages to the semiconductor device package according to the invention:
* Self and mutual inductances and characteristic impedance of the signal lines are lowered, thereby reducing package electrical noise and cross talk, and increasing circuit switching and speed;
* a second return path is provided for the power lines in addition to the first return path through the first metal layer.

In FIG. 2, a few solder balls 206 are intended for electrical ground potential and shown as electrically connected to electrically conductive adhesive 230, which attaches heat spreader 205 to insulating film 211. The majority 240 of solder balls is intended for connecting to signal and power lines.

It should be noted that conductive adhesive 230 is preferably applied to spread over a wide area of insulating film 211, preferably as far as the curved form 205a of heat spreader 205 allows. In FIG. 2, it reaches at 230a a borderline close to edge 201a of IC chip 201. When conductive adhesive 230 is fabricated in this preferred fashion, it covers as much area of the second metal layer 216 (with its signal and power lines) as possible. Consequently, the beneficial effects, exerted by the additional ground potential on the electrical device characteristics listed above, are maximized.

As an example of the electrical improvements provided by the additional ground plane of the invention, FIG. 3 shows the reduction of signal line, or power line, inductance (axis denoted 301) achieved by the diminishing separation from the additional ground plane (axis 302). When the insulating film (denoted 111 in FIG. 1 and 211 in FIG. 2) separating the conductive adhesive at ground potential and the signal lines and power lines is fabricated at 0.02 mm thickness (point 302a), the inductance of the signal/power lines is reduced to 0.005 nH (data point 301a). This value represents more than an order of magnitude (approximately 20 times) reduction of signal/power line inductance compared to the value 0.1 nH (data point 301b) observed without the additional ground plane.

In FIG. 4, the reduction of inductance is defined as "improvement". The improvement is plotted (as ordinate 401) in factors compared to the design without additional ground plane (for instance, x10 representing one order of magnitude reduction of inductance), with the abscissa (denoted 402) indicating the separation of the signal lines and power lines from the additional ground plane. Data point 401a indicates an approximately 20-fold improvement of the inductance achieved by positioning the additional ground plane at a separation of 20 µm from the signal lines.

While this invention has been described in reference to illustrative embodiments, this description is not intended to be construed in a limiting sense. Various modifications and combinations of the illustrative embodiments, as well as other embodiments of the invention, will be apparent to persons skilled in the art upon reference to the description. As an example, the material of the semiconductor chip may comprise silicon, silicon germanium, gallium arsenide, or any other semiconductor material used in manufacturing. As another example, the package may be a BGA package or any other semiconductor device package. As another example, after the flip-chip solder attachment process, a stress-reducing underfill may be applied, or not. As another example, the electrically adhesive may be fabricated by a dispensing process using viscous material dropping from a syringe, or by using a pre-fabricated tape. It is therefore intended that the appended claims encompass any such modifications or embodiments.

## Claims

1. A high-performance integrated circuit package having signal and power lines, comprising:
a first electrically conductive layer (115) suitable to provide ground potential;
a second electrically conductive layer (105), also at ground potential;
said first and second electrically conductive layers (115, 105) positioned on opposite sides of said signal and power lines so that self and mutual inductances are lowered, whereby package electrical noise and cross talk are reduced and circuit switching and speed are increased.

2. The package of claim 1 wherein said second electrically conductive layer is a heat spreader (105) electrically connected electrical ground potential.

3. The package of claims 1 and 2, providing a high I/O ball grid array package comprising:
a substrate (110) having a first patterned metal layer (115) to provide electrical ground potential;
the exposed surface of said first metal layer protected by a first insulating film (112) having first metal-filled openings (112a) suitable for solder attachment;
said substrate (110) further having a second patterned metal layer (116) to provide signal and power lines;
the exposed surface of said second metal layer protected by a second insulating film (111) having second metal-filled openings (123) suitable for solder attachment;
said substrate (110) further having an insulating layer (113) between said first and second layers, said insulating layer (113) traversed by a plurality of metal-filled vias (114);
an integrated circuit chip (101) having a passive surface (101b) and an active surface (101a) including solder bumps (102),
said solder bumps (102) adhered to said second openings;
a heat spreader (105) thermally attached to said passive chip surface (101b), said heat spreader (105) being on one side of said signal and power lines, and said first patterned metal layer (115) being on the opposite side of said signal and power lines;
an electrically conductive adhesive (130) operable to attach said heat spreader (105) to said second insulating film (111) of said substrate (110) and further to selected vias (114) through said insulating layer (111); and
a plurality of solder balls (106) attached to said first openings (112a), a selected number thereof providing electrical ground potential to said metal layer (115) and to said selected vias (114) contacting said conductive adhesive, whereby ground potential is provided to said heat spreader (105), providing for said power lines a second return path in addition to the first return path in said first metal layer (115).

4. The package according to Claim 3 wherein said electrically conductive adhesive (130) is selected from a group consisting of silver-filled epoxy, plastic spheres or rods covered with metal, a multitude of electrically conductive fibers extending through an electrically nonconductive and adhesive layer from one surface to the opposite surface, or generally metal particles suspended in plastic and adhesive materials.

5. The package according to Claim 3 wherein said first and second insulating films (111, 112) are glass-filled epoxies, polyimides, acrylics or other photo-imageable materials suitable as solder masks and have a thickness between about 10 to 30 µm.

6. The package according to Claim 3 wherein the proximity of said electrically conductive adhesive (130) to said signal lines decreases cross talk, inductance and characteristic impedance of said signal lines.

7. The package according to Claim 3 wherein the number of said I/O's ranges from about 100 to 600.

8. The package according to Claim 3 wherein the thickness of said package is in the range from about 300 to 1100 µm, including the thickness of the heat spreader (105).

9. The package according to Claim 3 wherein said insulating layer (113) is made of organic material and is selected from a group consisting of polyimide, polymer strengthened by glass fibers, FR-4, FR-5, and BT resin; said insulating layer having a thickness between about 50 and 120 µm.

10. A method for fabricating a high performance, high I/O ball grid array package, comprising the steps of:
providing a substrate (110) having two metal layers (115, 116) and an intermediate insulating layer (113) including a plurality of metal-filled vias (114) in said insulating layer (113);
forming said metal layers (115, 116) such that one said metal layers (115) is suitable to provide electrical ground potential, and the other said metal layer (116) is suitable to provide electrical signal and power potentials;
forming insulating protective films (111, 112), suitable as solder masks, over the exposed surfaces of said metal layers (115, 116) in such thickness that they are operable to reduce electrical inductances of said signal and power lines;
forming pluralities of openings (123, 112a) in both said insulating films (111, 112), and filling said openings with solderable metal, thereby creating attachment sites for outside solder balls and for chip solder bumps;
attaching an integrated circuit chip (101), having an active surface (101a) including solder bumps (102) and a passive surface (101b), by adhering said solder bumps (102) to said plurality of metal-filled openings in one said insulating films;
attaching one portion of a heat spreader (105) to said passive chip surface (101b);
attaching the remaining portions of said heat spreader (105) to said insulating film (111) having said chip (101) attached, using an electrically conductive adhesive (130); and
attaching solder balls (106) to said plurality of metal-filled openings (112a) in the other said insulating films (112).

11. The method according to Claim 10 wherein said conductive adhesive (130) is applied to the most surface of said insulating film (111) permissible without contacting said chip (101).
